# EUROPEAN PATENT APPLICATION

(11) **EP 2 211 194 A1**
(43) Date of publication of application: **28.07.2010**
(21) Application number: 08845650.4
(22) Date of filing: 29.10.2008
(51) Int. Cl.: G01R 33/07

(54) **PHYSICAL AMOUNT DETECTION DEVICE**

(30) Priority: 29.10.2007 JP 2007280739
(71) Applicant: Tokyo Institute of Technology, Tokyo 152-8550 (JP)
(72) Inventor: UEDA, Tomoaki, Tokyo 152-8550 (JP); ABE, Masanori, Tokyo 152-8550 (JP); NAKAGAWA, Takashi, Tokyo 152-8550 (JP); TADA, Masaru, Tokyo 152-8550 (JP); MIZUMOTO, Tetsuya, Tokyo 152-8550 (JP); HANDA, Hiroshi, Yokohama-shi Kanagawa 226-8503 (JP); SANDHU, Adarsh, Tokyo 152-8550 (JP); ARAKI, Kiyomichi, Tokyo 152-8550 (JP)
(74) Representative: Kramer - Barske - Schmidtchen
(86) International application number: PCT/JP2008/069622
(87) International publication number: WO 2009/057626

(57) **Abstract**

Provided is a highly sensitive sensor system that can improve the S/N ratio by use of an electronic circuit without complicating the sensor body or degrading temporal resolution. A broad spectrum sensor element outputs an electric signal corresponding to a detected physical quantity, the sensor driven by multiplying a carrier signal by m-sequence code. The spread spectrum signal, after phase adjustment, is used to demodulate the sensor output signal, which corresponds to the broad spread spectrum of the physical quantity. The electrical noise generated in the sensor is a broad spread spectrum and is suppressed by low-pass filtering so as to improve the S/N ratio.

## Description

### [Technical Field]

The present invention relates to a physical quantity detection device with high detection sensitivity.

### [Background Art]

Our everyday lives presently depend on sensor systems to detect various physical quantities. For many applications of a sensor system, a higher sensitivity, resolution, and stability are required. For example, recent developments in nanotechnology and biotechnology demand sensor systems with high sensitivity and higher resolution.

In order to increase the sensitivity and resolution of a sensor system, the output of a sensor element must not only be amplified but also the noise component, which interferes with the output signal from the sensor element, must be reduced as small as possible so as to increase the signal-to-noise ratio (S/N ratio) of a sensing signal from the sensor element.

A concrete embodiment of the sensor system will be described referring to a magnetic sensor system that uses a Hall element. Non-patent document 1 ("Magnetic Sensor," Electronic Component and Application Guide, Ninth Edition, Transistor Technique, published by CQ Publishing Co., Dec. 2005) explains in detail, a magnetic sensor system using Hall elements.

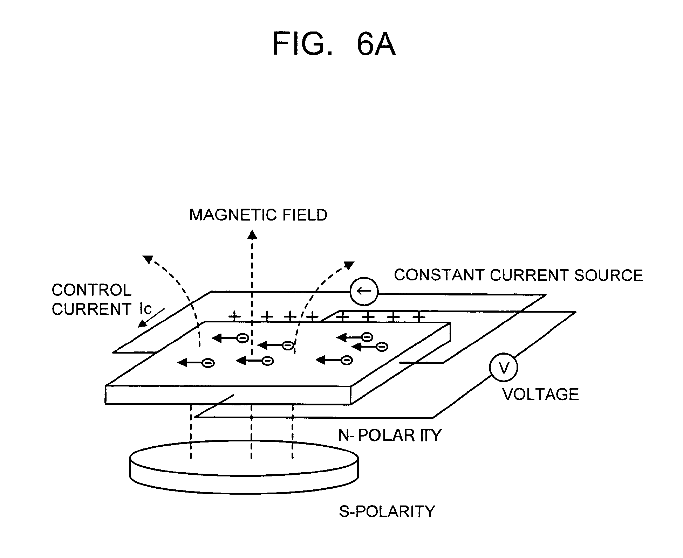

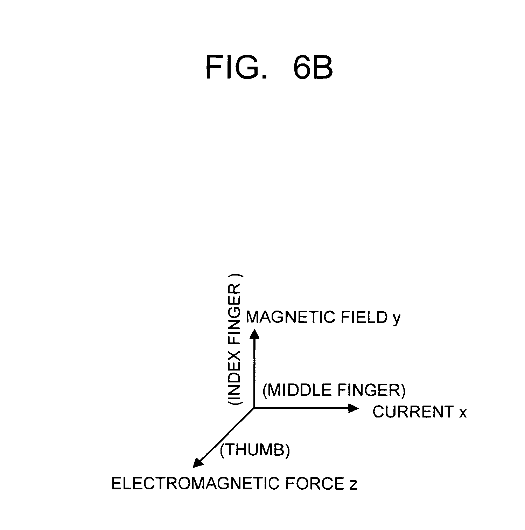

As explained in Non-patent document 1, the Hall element is a small magnetic semiconductor sensor that has good linearity and produces an output voltage that is proportionate to the external magnetic flux density by running a current therein. Fig. 6 shows a figure of the fundamental operating principle of a Hall element. The Hall element is made by a semiconductor such as indium antimonide (InSb) or gallium arsenide (GaAs) and has a control current input terminal pair and voltage output terminal pair.

When a current flows in the semiconductor along the direction designated by "x", the electrons flow in the opposite direction in the semiconductor. In this case, if an external magnetic field is applied to the semiconductor along the direction designated by "y", the electrons are subject to respective electromagnetic forces, called Lorentz forces, so that the direction of movement of the electrons is changed gradually, resulting in the electrons being migrating towards the front of the "z" direction and the electron donors, being positively charged, migrating towards the back of the "z" direction. Therefore, an electric field is generated that balances out the force received in the z direction, and, as a result, a difference in potential appears between the voltage measuring terminals. During this balanced state, the current flowing in the x direction of the semiconductor keeps going straight. The directions of the Lorentz forces follow Fleming's left-hand rule are as shown in Fig. 6B. Supposed that if the middle finger designates the direction of the current and the index finger designates the direction of the magnetic field, the thumb designates the directions of the Lorentz forces for the respective electrons. From this point of view, if the direction of the magnetic field is reversed, the direction of the electric field to be generated is also reversed so as to change the polarity of the output voltage. If the intensity of the magnetic field is changed, the intensity of the electric field is also changed so as to proportionally change the amplitude of the output voltage. This phenomenon is called the Hall Effect since this phenomenon was discovered by E. H. Hall in the United States.

A Hall element has the advantage of an extremely wide dynamic range in measurement as compared to a magnetic resistive (MR) sensor or a magnetic impedance (MI) sensor, making the Hall element widely available in many industrial application fields as of now. However, a Hall element has a disadvantage of lower detection sensitivity in comparison with other sensors so that the application fields of the Hall element are restricted in performance in view of the lower detection sensitivity.

The main noise components of the Hall element are 1/f noise and thermal noise, called Johnson noise, which limit the Hall element's sensitivity. Here, the 1/f noise has particularly a significant contribution at low frequencies. Additionally, Johnson noise is white noise generated by the thermal behavior when a current flows through a resistor, the value of the voltage given by the equation (4kRTΔf)^{1/2}, where T is the absolute temperature (in Kelvin), k is defined as Boltzmann's constant (1.3806503 * 10⁻²³m² * kg * s⁻² * K^{-t}), R is the Hall element resistance (in ohms Ω), and Δf is the measurement frequency bandwidth (in hertz Hz).

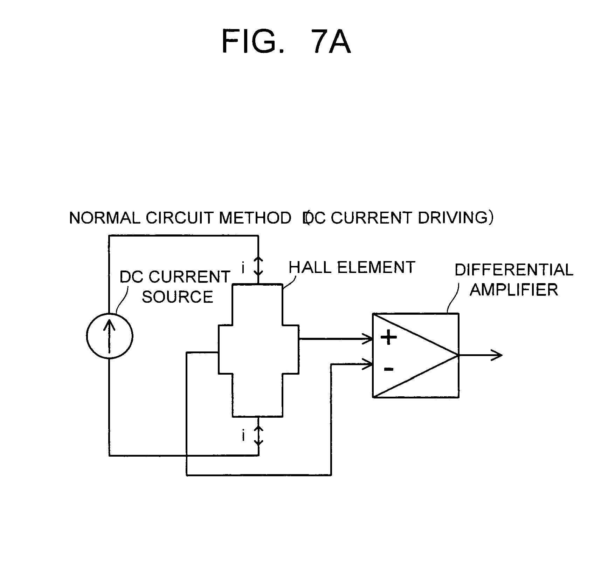

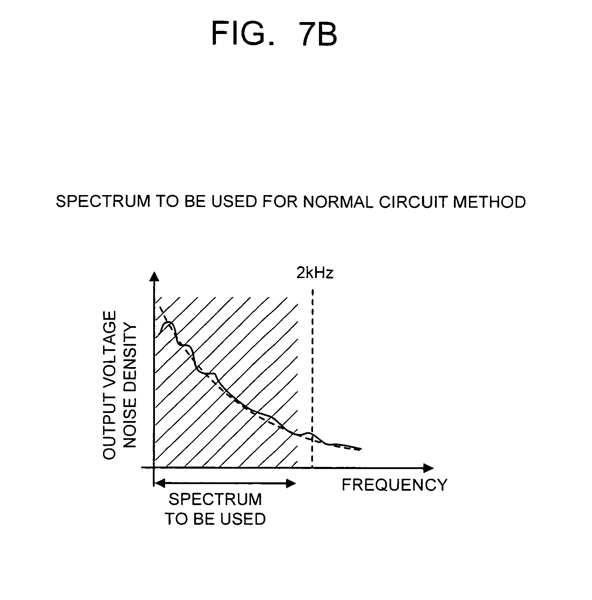

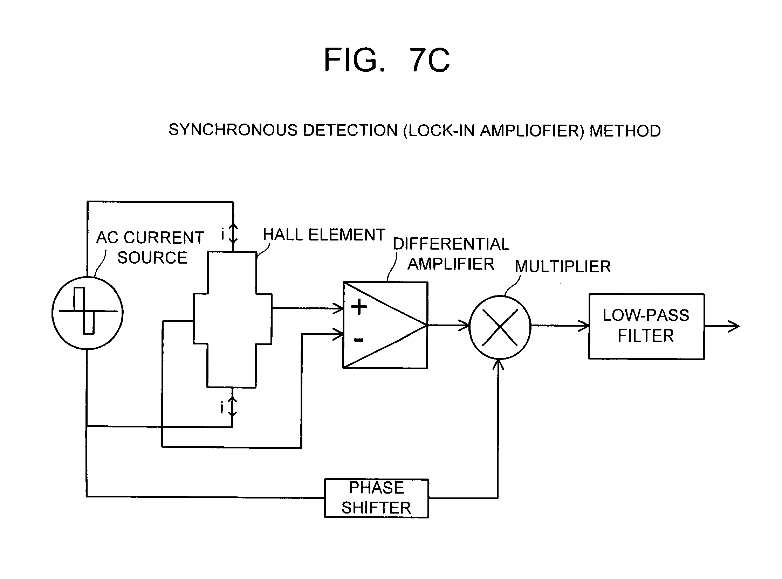

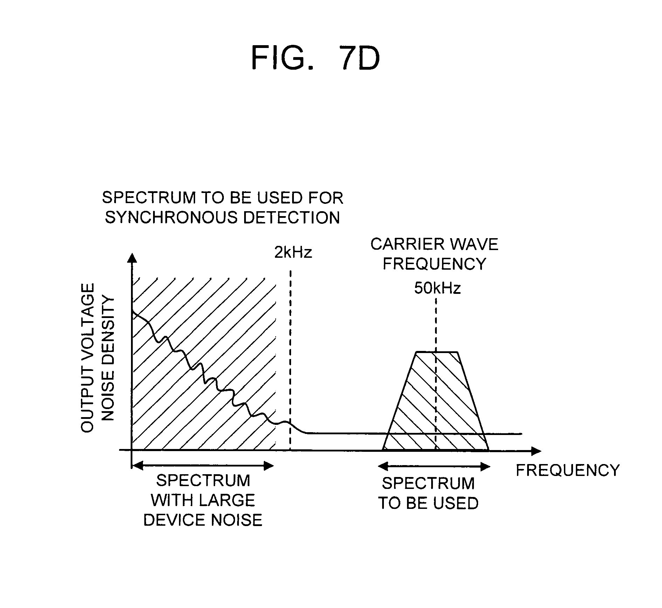

In the case of normal industrial applications, the Hall element is driven by a DC constant current, as shown in Fig. 7A. As shown in Figure 7B, the serious effect of 1/f noise on low frequencies is such that, if the bandwidth is narrowed, the S/N ratio degrades. For highly sensitive magnetic field measurements using the Hall element, in order to minimize the influence of noise such as low frequency 1/f noise, a high frequency carrier wave current is applied through the Hall element to generate Hall voltage commensurate with the frequency of the carrier wave, as shown in the block diagram of Figure 7C. The detection of the generated Hall voltage is conducted using a synchronous detection method where the carrier wave becomes the standard reference wave. The synchronous detection circuit is called a lock-in amplifier.

In Fig. 7C, the output current from the AC current source is applied to the Hall element as a carrier wave signal so that, from the Hall element, the Hall voltage proportionate to the magnetic field detected by the Hall element is output at the original carrier wave frequency. The Hall voltage of this carrier wave frequency is amplified by an amplifier and fed to a multiplier. An output signal from the standard reference wave signal generator is first adjusted in phase via a phase shifter and then fed to the multiplier. The multiplier detects the Hall voltage using the synchronous detection method with the phase-adjusted signal from the phase shifter as a reference signal. The synchronously-detected Hall voltage is passed through a low pass filter so that a given output proportionate to the magnetic field detected by the Hall element can be obtained.

Even with the use of a synchronous detection method, however, the resolution of the magnetic measurement is influenced by noise such as Johnson noise and external interference signal noise. For this reason, when using a Hall element, the sensitivity of a magnetic sensor system for detecting a signal using the synchronous detection method is still limited to an approximate range of 1 to 10 milligauss (mG).

As a method for reducing the influence of noise, by averaging the obtained result of n data points while conducting a sensing process n-times, the effect of noise on a given signal is reduced to 1/n^{1/2}. In the case of the lock-in amplifier, this averaging is achieved by making the integration time longer to reduce the influence of noise on a given signal. At the same time, the sensing process of this method can be time consuming, and, for example, using a longer integration time, an increased number of samplings, or the like, will result in the time resolution being degraded to 1/n.

If the sampling rate is improved n-fold while maintaining the sampling resolution, the time resolution can be maintained. But, in this case, a very expensive, high-speed A/D converter and arithmetic processing for averaging will also be required. Non-patent document No. 1:"Magnetic Sensor", Electronic Component and Application Guide, Ninth Edition, Transistor Technique, December, 2005, published by CQ Publishing Technique.

### [Disclosure of Invention]

### [Technical Problem]

It is therefore desired to realize a sensor system with high sensitivity while reducing the effects of noise such as 1/f noise and Johnson noise on a given signal without deteriorating the time resolution of the sensor. In the development of a sensor element with high sensitivity, however, a huge investment in R&D has been made to use new materials, establishment of a manufacturing method and long-period endurance testing. If possible, it is desirable to develop a sensor with high sensitivity sensor independent of these processes. The present invention meets theses demands, and the sensor itself, using existing devices and electronic circuits for signal processing technology, provides for a sensor with high sensitivity sensor system whose sensor signal is less subjected to the influence of noise.

### (Means of solving the problem)

A physical quantity detection device according to the present invention includes: a broad spectrum sensor 1 for outputting an electric signal corresponding to a physical quantity detected through the electric drive; a spread spectrum signal generator 2 for generating a spread spectrum signal; a spread spectrum sensor driving circuit 3 for driving the broad spectrum sensor 1 on a spread spectrum signal output from the spread spectrum signal generator 2 and for outputting, as a spread spectrum output signal, the electric signal corresponding to the physical quantity detected by the broad spectrum sensor 1; a demodulation circuit 4 for de-spreading the spectrum of the electric signal corresponding to the physical quantity detected by the broad spectrum sensor 1 into a required bandwidth of the physical quantity to be measured through a synchronous detection for the spread spectrum output signal from the broad spectrum sensor 1 by using the spread spectrum signal output from the spread spectrum signal generator 2 and for low-pass filtering the electric signal while a noise component having no correlation with the spread spectrum signal, used for the driving of the broad spectrum sensor 1, being spread in a broad spectrum.

Here, the bandwidth means a frequency bandwidth, and the required bandwidth for the physical quantity is required for sensing the physical quantity with the corresponding sensor. For example, the bandwidth necessary for the detection of the rotation of a rotation sensor can be exemplified. Moreover, it is preferable that a pseudo-random signal is employed to generate the spread spectrum signal. Here, the pseudo-random signal is periodic and non-random but has an appearance of being a signal with randomness similar to a true random signal. A broad spectrum sensor refers to a sensor that outputs an electric signal, whose spectrum is broadly spread, according to the detected physical quantity while being electrically driven by the spread spectrum driving circuit.

In the physical quantity detection device of the present invention, various sensors may be used as the broad spectrum sensor 1 depending on their purpose, each sensor being able to output an electric signal corresponding to the detected physical quantity while the spectrum is spread. As one of the sensors, a Hall element may be used for magnetic measurement. In the physical quantity detection device of the present invention, when the Hall element may be used as the broad spectrum sensor 1, the detection device can conduct the detection and measurement of a magnetic field at an extremely higher sensitivity than by using a conventional sensor so that new applications can be developed for Hall elements.

In the physical quantity detection device of the present invention, in order to realize a sufficiently high sensitivity, the spread spectrum signal generated by the spread spectrum signal generator 2 may employ an m-sequence code. It is desirable that the m-sequence code is generated using a clock frequency at least ten times as large as the required bandwidth of the physical quantity to be measured. The m-sequence code can be easily generated by a clock oscillator, an n-stage shift register, and at least one XOR gate. Since the m-sequence code is a binary quantization code, it becomes easy to design an intended sensor driving circuit and demodulation circuit.

In the physical quantity detection device of the present invention, the spread spectrum signal to be generated from the spread spectrum signal generator 2 may be generated by phase-modulating a carrier wave having a sine wave or square wave according to the logic value of the m-sequence code, which is generated by using a clock frequency at least ten times as large as the required bandwidth by the physical quantity to be measured. By using the spread spectrum signal, the detection of the physical quantity can be conducted without detecting low frequency noise such as 1/f noise or environmental noise, which is advantageous in improving the S/N ratio.

In the physical quantity detection device of the present invention, the spread spectrum signal to be generated from the spread spectrum signal generator 2 may be generated by frequency-modulating a carrier wave having either a sine wave or square wave shape according to the logic value of the m-sequence code, which is generated by using a clock frequency that is at least ten times as large as the required bandwidth of the physical quantity to be measured. If the spread spectrum signal is used, the bandwidth can be uniformly increased and the S/N ratio can be greatly enhanced.

In the physical quantity detection device of the present invention, the sensor driving circuit 3 may be a differential output circuit. In this case, the deterioration of an S/N ratio of the electric signal corresponding to the physical quantity due to the difference in the properties of the rise and fall of a signal can be suppressed by the sensor driving circuit 3 as the differential output circuit.

A physical quantity detection method according to the present invention includes the steps of: outputting an electric signal corresponding to a physical quantity detected through an electric drive of a broad spectrum sensor; driving the broad spectrum sensor and outputting a spread spectrum signal, the electric signal corresponding to the physical quantity detected by the broad spectrum sensor; de-spreading the electric signal corresponding to the physical quantity detected by the broad spectrum sensor into the required bandwidth for the physical quantity to be measured through synchronous detection spread spectrum of the spread spectrum signal output; and low-pass filtering the electric signal while a noise component having no correlation with the spread spectrum signal, used for the driving of the broad spectrum sensor being spread in a broad spectrum, thereby outputting the physical quantity to be measured in the required bandwidth.

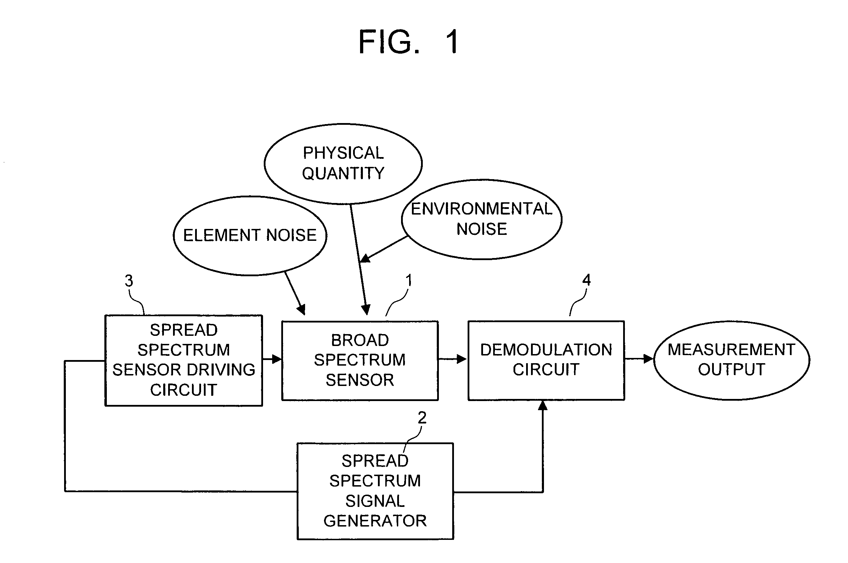

Fig. 1 is an explanatory view of the fundamental structure of the high sensitivity physical quantity detection device. In Fig. 1, a physical quantity with environmental noise is sensed and input into a broad spectrum sensor 1. Some element noises such as Johnson noise, 1/f noise, and the like are also input into the broad spectrum sensor 1. The broad spectrum sensor 1 is driven by the spread spectrum signal generated by a spread spectrum signal generator 2 and generates a sensor signal whose spectrum is spread. The spread spectrum sensor signal is demodulated at the demodulation circuit 4 to be the measured output. In such a structure, when the bandwidth of the sensor sensing the physical quantity is defined as W (in hertz Hz) and the frequency bandwidth of the spread spectrum by the spread spectrum signal is defined as fₘ[Hz], the physical quantity is detected in a bandwidth W/fₘ times as large as the bandwidth inherently required so that the S/N ratio becomes (W/fₘ)^{1/2} times as large as the original one.

According to the present invention, the 1/f noise and the thermal noise, called Johnson noise, which are superimposed on the sensor output signal are spread and suppressed electrically and are thus remarkably reduced. In the field of telecommunications, such a communications system using a spread spectrum is well known, as described in "Much Expected Spread Spectrum System", June 29, 1978, published by Asahi Shinbun, and in "New Spread Spectrum System", R.C. Dixon, published by Jateck Publishing Co., Ltd. In order to clarify the meaning of the present invention, the difference between the present invention and the spread spectrum system will be explained. The differences will be described below.

The history of the spread-spectrum communication system, which is now widely available in the field of cellular phones or wireless LAN, began with U.S. Patent 2,292,387, "Secret communication System," which related to the art of frequency hopping spread-spectrum and which was obtained by co-inventors Hedy Kiesler Markey (also known as Hedy Lamarr, whose real name was Hedwig Eva Maria Kiesler), a Hollywood actress from Vienna, Austria, and George Antheil, a composer, on August 11, 1942. The invention can realize the secret communication system by subsequently selecting a frequency to be used for communication from among 88 frequencies, the same number as that of the keys of a piano of an automatic playing piano roll. However, this technique was not employed for twenty years until the U.S. Navy employed the technique in the Cuban Missile Crisis of 1962. It was at the Consultative Committee on International Radio (CCIR) held in Kyoto, Japan in 1978 that the technique of code division multiple communication methods came to be noticed as an efficient use of limited radio resources. It is known that if codes having low correlation with each other are selected for the m-sequence code to be used as the pseudo-noise spread spectrum, it enables, for example, 90,000 communication code division multiple channels within a bandwidth of 1 MHz. The technology has been adopted in standard narrow-band communication systems, since only about 300 channels could be allotted within a bandwidth of 1 MHz, the communication system leading to significant breakthroughs for communication technology. As of now, the spread spectrum communication is widely available and spread in the field of cellular phones or wireless LANs, after 65 years from when the corresponding patent was first obtained and after 29 years from when the CCIR was held in Kyoto, Japan.

However, in the field of measurement, the sharp autocorrelation properties as one of the mathematics properties of the m-sequence code are not sufficiently utilized except for measurement techniques related to the propagation delay time of radio waves, optical waves, or ultrasonic waves. The measurement technique is a technique for finely measuring the distances from a plurality of sources using the autocorrelation properties of the m-sequence code. The most popular example of this measurement technique is that widely used in GPS (Global Positioning System) car navigation systems. In the measurement technique, it is an object of the invention to calculate the three-dimensional coordinates for a distance measured between multiple points, modulating the action of the signal properties with an autocorrelation sensor with improvement in high sensitivity, a non-obvious improvement. Japanese Patent laid-open JP 2006-218013 (KOKAI) teaches of an invention related to a method and device where an optical signal modulated with spread spectrum is transferred to a living body and received through the inverse spread thereof. However, that invention relates to a communication technique where the field of the spread spectrum using the optical signal is set into the living body and is thus not used to enhance sensor sensitivity by applying a modulating signal with autocorrelation characteristics to the sensor.

Shannon's channel capacity theorem can be used to describe the improvement of the S/N ratio, where the sensor is electrically driven by the spread spectrum signal using the m-sequence code to generate a sensor output containing the information of the physical quantity, and the sensor output is demodulated such that the physical quantity information is restored in the original bandwidth and undergoes low-pass filtering while the noises are spread in a broad spectrum.

According to Shannon's channel capacity theorem, the channel capacity "C" is represented by:

C=Wlog₂(1+(S/N)) (1)

Here, "C" is the channel capacity (in bits per second bps), "W" is the bandwidth of the channel (in hertz Hz), "S" is the received signal power (in watts W), and "N" is the noise power (in watts W).

As apparent from equation (1), if "W" is increased□"C" is also increased. In the present invention, "C" can be considered as the information amount of the physical quantity to be detected by the sensor, and "S" can be considered as the signal power of the sensor. Therefore, it is anticipated that if the sensor is driven in a broad spectrum by the spread spectrum signal and "W" is increased so as to increase the information amount "C" of the physical quantity to be detected by the sensor, the influence of noise interference on the sensor signal can be suppressed by utilizing the mathematical and statistical characteristics of the spread code. Although twenty-nine years have elapsed since the spread spectrum communication technique became well known, a technique to enhance the sensitivity of a sensor using this principle has not yet been found.

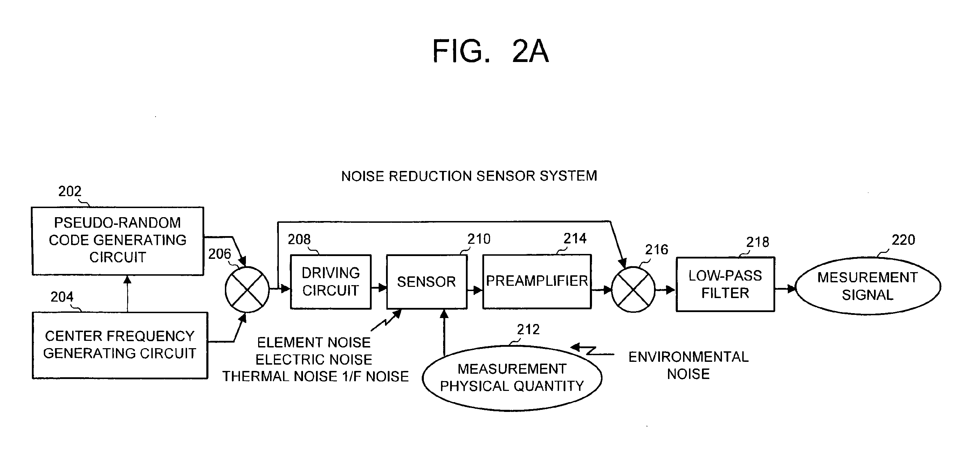

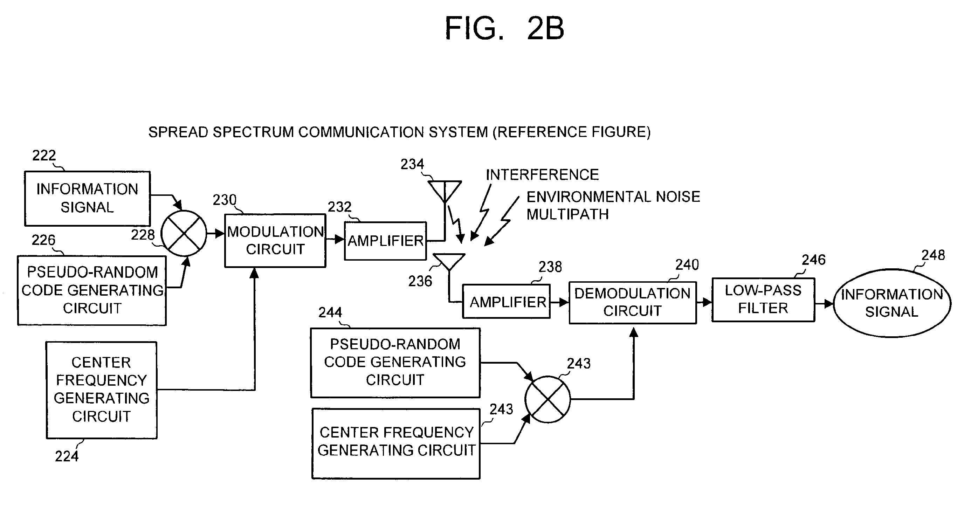

Fig. 2 relates to the noise reduction sensor system of the present invention, as compared to a typical spread spectrum communication system. Fig. 2A is a block diagram showing an embodiment of the noise reduction sensor system using the spread spectrum according to the present invention. In Fig. 2A, a pseudo-random code generated by a pseudo-random code generator 202 is multiplied with a center frequency generated by a center frequency generator 204 for generating the center frequency as a clock frequency at a first multiplier 206. The signal thus multiplied is input into a driving circuit 208 to generate a driving signal, which drives a sensor element 210. As a result, an electric signal corresponding to a measured physical quantity 212 obtained by sensing the measured physical quantity 212 is output from the sensor element 210 in the form of a spread spectrum. Then, the output signal from the sensor element 210 is amplified by a preamplifier 214 and input into a second multiplier 216. At the second multiplier 216, the output signal from the sensor element 210 is detected in synchronization using the output signal from the first multiplier 206 or the pseudo-random code generated by the pseudo-random code generator 202 while the high frequency components are removed by a low pass filter 218, thereby obtaining an intended measured signal 220.

For a contrasting view, Fig. 2B shows a block diagram of the communication system using the spread spectrum communication system as a comparison with the noise reduction sensor system using the spread spectrum according to the present invention. In Fig. 2B, an information signal 222 is input into a multiplier 228 on the transmission side and multiplied with a pseudo-random code by the multiplier 228. The pseudo-random code is output from a pseudo-random code generator 226 on the transmission side. A signal generated by a center frequency generator 224 on the transmission side is input as a center frequency into the pseudo-random code generator 226. The signal thus multiplied is modulated by a modulation circuit 230 by an output signal from the center frequency generator 224 on the transmission side, amplified by an amplifier 232 on the transmission side, and transmitted via an antenna 234 on the transmission side. The information signal thus transmitted is received at an antenna 236 in the reception side, amplified by an amplifier 238 on the reception side and demodulated by a demodulation circuit 240. The demodulation is conducted using a pseudo-random code multiplied with a center frequency generated by a center frequency generator 242 on the reception side and an output signal from a pseudo-random code generator 244 on the reception side. The signal thus demodulated is low-pass filtered by a low pass filter 246 to generate an intended information signal 248.

Fig. 2A of the present invention is related to the pseudo-noise generator 202, used for both of the spread spectrum and the inverse spread spectrum. It is considered that the measured physical quantity 212 sensed by the sensor in the present invention can correspond to the information signal 222 in the spectrum communication. The effect of the present invention thus obtained effect is that, since the sensor element 210 is driven by the spread spectrum signal with the use of the inverse spread while the spread spectrum signal is low-pass filtered to obtain the measurement physical quantity, electric noise such as 1/f noise and Johnson noise can be spread and suppressed irrespective of the spread spectrum signal to modulate the measured physical quantity 212. Since environmental noise accompanying with the physical quantity to be measured cannot be separated from the measured physical quantity, environmental noise cannot be spread and suppressed.

In contrast, in the spread spectrum communication, the pseudo-noise generators are provided in both of the transmission side and the reception side in synch with one another, respectively so that static noise and interference related to the same physical quantity as an electromagnetic wave to be used for communication can be removed. However, the noise superimposed on an information signal to be transmitted and the Johnson noise (thermal noise) to be superimposed by the transmitter cannot be spread and suppressed. In this point, the spread spectrum communication is different from the present invention. In the present invention, a sensor itself is driven by a spread spectrum signal, and a sensed signal undergoes de-spreading and low-pass filtering.

In the sensor system of the present invention, the information of the physical quantity contained in the sensor output extracted while the broad spread spectrum signal is being demodulated into the original band while the noise spectrum is spread in a broad spectrum because the unnecessary components are removed and suppressed by low pass filtering so that the S/N ratio is improved. In this case, since it is not needed to increase the sensing time, the time resolution of the sensor is not deteriorated.

The spread spectrum communication system is widely available in fields requiring multi-channel communication, such as with cellular phones and the like. In this field of communication, a communication system can be realized using the above-described modulation system such that the number of channels in transmission and reception can be significantly increased and do not interfere with one another. In the communication using the spread diffusion modulation, however, white noise such as Johnson noise is superimposed on the signal on the transmission side, which cannot be reduced.

The inventors have paid attention to the interesting feature of the spread spectrum modulation using a spread code and have intensely promoted new applications of the spread spectrum modulation. Particularly, the spread spectrum modulation technique is applied to the sensor system such that the sensor is driven by the spread spectrum signal and the output signal is taken out as a spread spectrum modulated signal, which is then demodulated. In this case, noise such as Johnson noise contained in the output signal can be remarkably reduced so that the sensitivity of the sensor can be remarkably enhanced to form the present invention.

### [Advantageous Effects]

According to the present invention, the sensor is electrically driven by the spread spectrum signal so that the physical quantity sensed by the sensor is detected under the broad spread spectrum. The physical quantity is de-spread, demodulated, and filtered in a low-pass filter so as to be sensed in the original band. In addition, noise such as Johnson noise can be remarkably reduced. As a result, even though the performance of the sensor is not enhanced, the sensitivity of the sensor system containing the sensor can be enhanced by signal processing using the electric circuit.

### [Brief Description of Drawings]

Fig. 1 is an explanatory view for the fundamental structure of an embodiment of the physical quantity detection device of the present invention.
Fig. 2A is a block diagram relating to an embodiment of a noise reduction sensor system using the spread spectrum relating to the present invention.
Fig. 2B is a block diagram of a spread spectrum communication system as a reference to be compared with the block diagram shown in Fig. 2A.
Fig. 3A shows the state where spread spectrum signals are generated by selectively outputting a carrier wave with a frequency of 120 kHz at respective phases of 0 and 180 degrees per every three waves depending on the logic state of the m-sequence code.
Fig.3B is an explanatory views showing the improvement of the S/N ratio obtained by the spread spectrum.
Fig. 4 is a block diagram of an embodiment of the physical quantity detection device using a Hall element produced so as to confirm the operation principle.
Fig. 5 is a graph showing the noise level in the noise spread reduction system related to the present invention in comparison with the noise levels in a conventional synchronous detection system and a conventional DC driving system.
Fig. 6A is an explanatory view for the operation principle of the Hall element.
Fig. 6B is an explanatory view for Fleming's left-hand rule regarding the relation of the current x flowed in the Hall element, the magnetic field y, and the Lorentz force z.
Fig. 7 relates to a driving method of the Hall element and the available band range in a conventional technique.

### [Explanation of Reference]

- 1: broad spectrum sensor
- 2: spread spectrum signal generator
- 3: sensor driving circuit
- 4: demodulation circuit
- 202: pseudo-random code generator
- 204: center frequency generator
- 206: first multiplier
- 208: driving circuit
- 210: sensor element
- 212: measured physical quantity
- 214: preamplifier
- 216: second multiplier
- 218: low pass filter
- 220: measured signal
- 222: information signal
- 224: center frequency generator
- 226: pseudo-random code generators
- 228: multiplier
- 230: modulation circuit
- 232: amplifier
- 234: antenna
- 236: antenna
- 238: amplifier
- 240: demodulation circuit
- 242: center frequency generator
- 244: pseudo-random code generator
- 246: low pass filter
- 248: information signal
- 401: GaAs Hall element
- 402: m-sequence code generator
- 403: carrier wave oscillator
- 404: multiplier
- 405: differential logic output gate
- 406a, 406b: two resistors
- 407a, 407b: differential amplifier
- 408a, 408b: analog switch
- 409: differential output gate
- 410: phase shifter
- 411: rear amplifier
- 412: low pass filter

### [BEST MODE FOR CARRYING OUT THE INVENTION]

Hereinafter, the present invention will be described in detail with reference to the drawings.

In the physical quantity detection device of an embodiment of the present invention, as already shown in Fig. 1, the spread spectrum signal generating circuit is applied to the broad spectrum sensor, which is electrically driven by the spread spectrum driving circuit so that the output signal under the broad spread spectrum from the broad spectrum sensor is demodulated in the original band using the spread spectrum signal. In this way, when the requirement bandwidth of the sensor is defined as W [Hz] and when the frequency bandwidth of the spread spectrum by the spread spectrum signal is defined as fₘ [Hz], the physical quantity is detected in a bandwidth W/fₘ times as large as the bandwidth inherently required so that the S/N ratio becomes (W/fₘ)^{1/2} times as large as the original one. In the present invention, it is desired that the broad spectrum sensor can be modulated in a bandwidth at least ten times as large as the bandwidth of the physical quantity inherently required for its application. Moreover, the bandwidth of the output signal from the broad spectrum sensor is preferably set to be at least ten times as large as the bandwidth of the physical quantity inherently required for its application.

In the present invention, the spread code is multiplied with the carrier signal to generate the spread spectrum signal, which electrically drives the broad spectrum sensor. The spread code to be used for the generation of the spread spectrum signal can be chosen among various sequence codes. It is desired that the sequence codes available have a high orthogonality, high apparent randomness, balance, periodicity, and autocorrelation.

A pseudo-random noise sequence is exemplified among these sequence codes, and an m-sequence code is exemplified among the pseudo-random noise sequences. The m-sequence code can be generated by using the shift register on the basis of a primitive polynomial. The m-sequence code is preferable as the spread code to be multiplied to the carrier signal for generating the spread spectrum signal used in the present invention because the m-sequence code can satisfy the above-described requirements.

As a concrete embodiment of the broad spectrum sensor, the Hall element will be taken up and described in detail as an example of a concrete embodiment of the broad spectrum sensor. In almost all current uses of Hall elements, the Hall element is utilized in a DC-level frequency range of about 100 Hz to at most20 kHz. However, it is confirmed that the sensitivity characteristics of the Hall element still can be exhibited at a frequency of 200 kHz or more. In view of that, considering the Lorentz force due to the magnetic detection principle of the sensor, the sensitivity characteristics of the sensor may be developed to a frequency of 1 GHz or so. However, since the means for generating such a high frequency magnetic field has not yet been developed, the sensitivity characteristics of the frequency band of the Hall element are still unknown. In any case, the Hall element is one of the sensors satisfying the requirements of the broad spectrum sensor in the present invention.

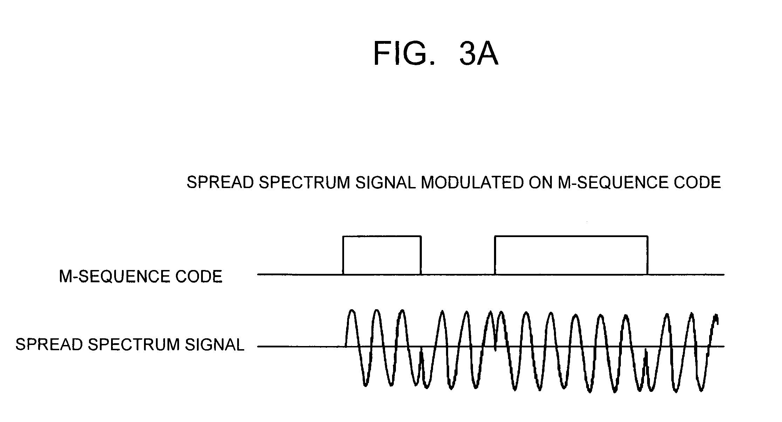

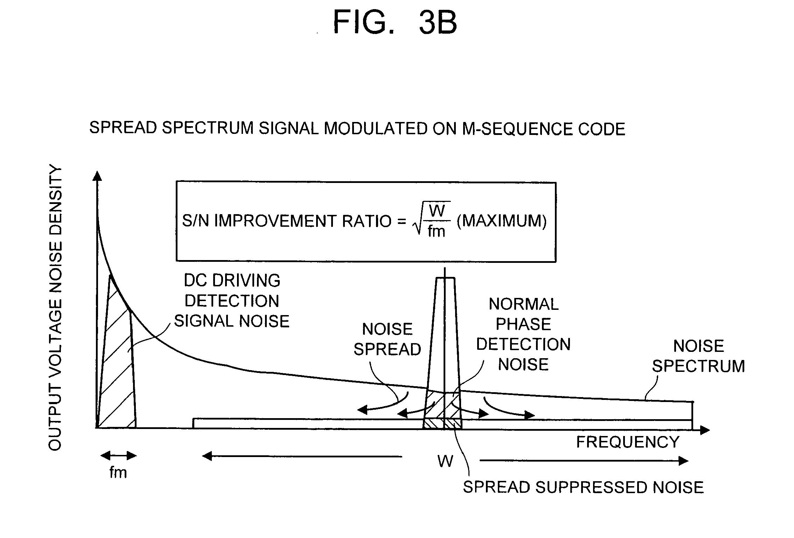

Fig. 3A is a view showing the relationship between the m-sequence code for generating the spread spectrum signal and the spread spectrum signal in the present embodiment. Fig.3B is a view showing the relationship between the voltage noise density and the frequency, explaining the improvement of the S/N ratio obtained by the spread spectrum when the signal is modulated through the spread spectrum by the spread spectrum signal and when the obtained spread spectrum signal is demodulated. As shown in the figures, the noise accompanying the detection signal detected by the direct current driving is reduced to within a low-frequency range by setting the detection method to a normal synchronous detection method. By using the synchronous detection method to spread and suppress noise by the noise spread relating to the present invention, noise can be remarkably reduced. In the present embodiment, the DC-level bandwidth required for a physical quantity is set up to 200 Hz from zero (DC) to 200 Hz. Moreover, the frequency of the carrier frequency is set to 120 kHz, the clock speed of the m-sequence code is set to 80 kHz, the code length is set to 4095 bits, and the spread spectrum is set to 80 kHz. As shown in Fig. 3A, the carrier wave with a frequency of 120 kHz is selectively output at the respective phases of 0 degree and 180 degrees per every three waves depending on the logic state of the m-sequence code to generate the spread spectrum signal. As shown in Fig. 3B, in this case, the improvement of the S/N ratio can be calculated at about (80000/200)^{1/2}=(400)^{1/2} = 20 times, maximum, of the original S/N ratio. In fact, since the shape of the envelop curve of the spectrum in the m-sequence code is not square-shaped, but (sinx/x)^{1/2} shaped, the improvement of the S/N ratio can be about 15 times that of the original S/N ratio, maximum.

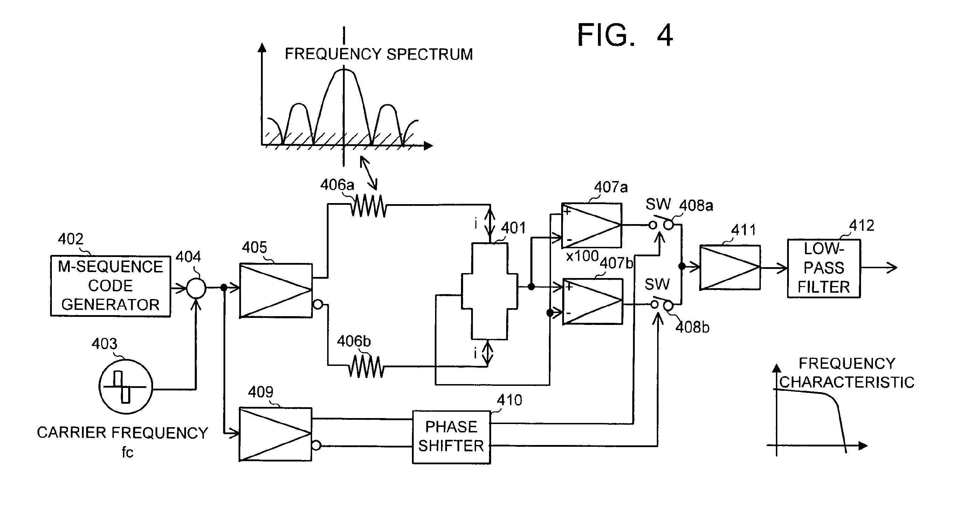

Fig. 4 is a block diagram of a physical quantity detection device using the Hall element in the present embodiment. A GaAs Hall element 401 corresponds to a broad spectrum sensor 1 of the present invention. A spread spectrum signal generator 2 is composed of an m-sequence code generator 402 and a carrier frequency f. A carrier wave oscillator 403 in hertz and a multiplier 404 and generates a spread spectrum signal with a timing as shown in Fig. 3A. A sensor driving circuit 3 is composed of a differential logic output gate 405 and two resistors 406a, 406b such that the constant voltage differential output is converted to the corresponding differential current output. The sensor driving circuit 3 is connected to the current supply terminals of the Hall element 401 so that the Hall element 401 can be electrically driven in a broad spectrum. A demodulator as the demodulation circuit 4 in the present invention is composed of: differential amplifiers 407a, 407b connected to the voltage supply terminals of the Hall element 401 at different polarities, respectively; analog switches 408a, 408b for selecting either one of the output signals from the differential amplifiers 407a, 407b depending on the logic state of the spread spectrum signal and for supplying the selected signal to a rear amplifier 411; a differential output gate 409 for conducting the on/off switch for analog switches 408a, 408b to smoothly change the logic state of the spread spectrum signal; a phase shifter 410 for conducting phase control so as to conduct synchronous detection appropriately on the basis of the supply of the spread spectrum signal from the differential output gate 409; the rear amplifier 411 for amplifying the signal selected and detected through the on/off switch of the analog switches 408a, 408b composing the multiplier functioning as a central mechanism in the synchronous detection, the analog switches 408a, 408b conducting the switching operation selectively and exclusively dependent on the spread spectrum signal; and a low pass filter 412 for removing the ripple of the amplified detection signal.

The circuit shown in Fig. 4 is a physical quantity detection device that is controlled by a one-chip microcomputer (not shown) and that conducts the noise spread reduction treatment using the spread spectrum signal on the basis of the m-sequence code related to the present invention. The physical quantity detection device is configured so as to operate as a conventional DC constant current driving circuit and as a synchronous detection circuit using the carrier wave, in addition to operating as a physical quantity detection device for conducting noise spread reduction using the spread spectrum signal on the basis of the m-sequence code related to the present invention.

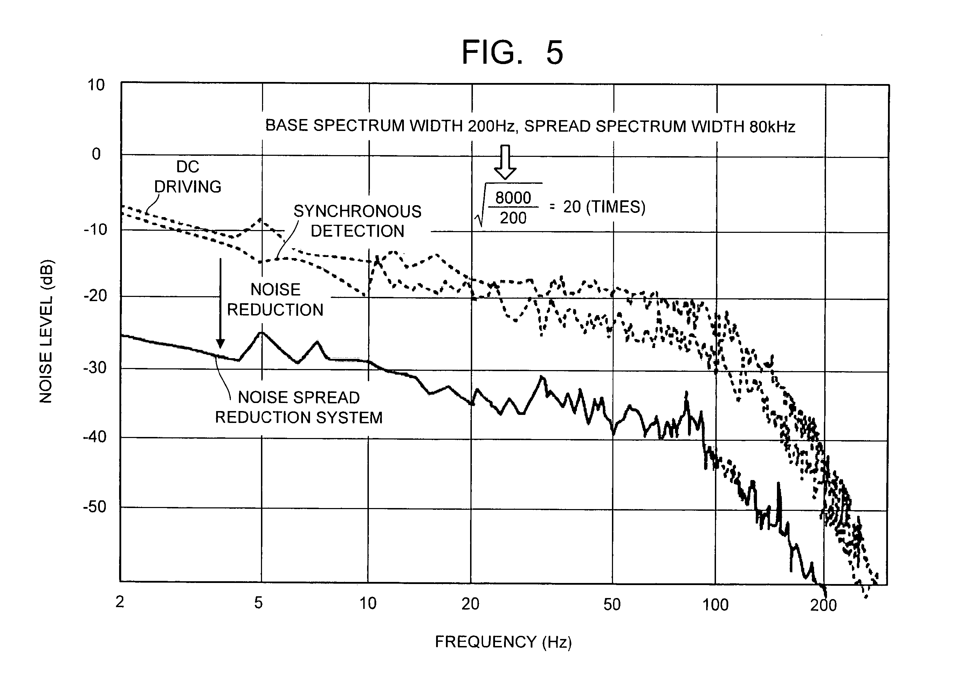

In this point of view, the noise level obtained when the physical quantity detection device is driven as the inherent operation mode of the physical quantity detection device, which conducts noise spread reduction using the spread spectrum signal on the basis of the m-sequence code compared with the noise level when the physical quantity detection device is driven as the operation mode of the DC constant current driving circuit and as the operation mode of the synchronous detection circuit using the carrier wave. Figure 5 shows the measured noise in each mode. A result is that the noise level when the physical quantity detection device is driven as the inherent operation mode, using the spread spectrum signal using the m-sequence, is improved by 20 dB, with no reduction of the time resolution than when the noise levels when the physical quantity detection device is driven as the operation modes of the DC constant current driving circuit and the synchronous detection circuit using the carrier wave. As previously described, in the present embodiment, the base bandwidth is set to 200 Hz while the spread bandwidth is set to 80 kHz, so that the estimated improvement of the S/N ratio can be calculated as approximately (80000/200)^{1/2} = (400)^{1/2} = 20 times that of the original S/N ratio, maximum. The measurement result related to the improvement of the S/N ratio confirms the calculation prediction related to the S/N ratio. If the spread bandwidth is further increased, the S/N ratio can be further improved. Thus, the noise can be significantly reduced by the noise spread reduction of to the present invention. In the present embodiment, since the frequency of the carrier wave is separated from the frequency of the DC constant current only by 120 kHz, there may be some degree of spread spectrum folding that may deteriorate the performance of noise reduction.

For the case when high sensitivity and low noise are required for the physical quantity even though the time resolution for the physical quantity is deteriorated, the data relating to the physical quantity is obtained n-times in turn, and a weighted average is conducted for the n-data thus obtained, thereby greatly reducing the noise component of the physical quantity.

In this example, although the physical quantity detection device employs the Hall element as the sensor element to conduct the magnetic measurement, the physical quantity detection device may be used for the detection of various physical quantities. For the sensor element to be used as a magnetic detection and magnetic measurement device, a magnetic resistive effective element such as an anisotropic magnetic resistive effective element, a giant magnetic resistive effective element, or a magnetic impedance element can be used in addition to using a Hall element. In addition to magnetic fields, the physical quantities to be measured can be electric fields, electromagnetic waves, light, temperature, humidity, and pressure. For the sensor element, various sensors can be used such as pressure-sensitive sensors, odor sensors, gyro sensors, thermocouple sensors, thermistors, and the like only if the sensor element can detect a physical quantity and output an electric signal corresponding to the physical quantity from the sensor element.

### [Industrial Applicability]

According to the present invention, only by an electronic circuit can the effect of the s/n ratio be significantly reduced for the sensor itself without applying any processing, which can greatly increase the sensitivity of the sensor. Therefore, it is considered that the present invention will be widely available for various industries in the future.

## Claims

1. A physical quantity detection device, comprising:
a broad spectrum sensor 1, being electrically driven, for outputting an electric signal corresponding to the physical quantity thus detected;
a spread spectrum signal generator 2 for generating a spectrum-spread signal;
a spread spectrum sensor driving circuit 3 for driving said broad spectrum sensor 1 on a spread spectrum signal output from said spread spectrum signal generator 2 so as to spread the spectrum of the electric signal output from the broad spectrum sensor;
a demodulation circuit 4 for de-spreading the spectrum of said electric signal corresponding to said physical quantity detected by said broad spectrum sensor 1 into the required bandwidth for said physical quantity to be measured through synchronous detection by using said spread spectrum signal output from said spread spectrum signal generator 2, and for low-pass filtering said electric signal while a noise component having no correlation with said spread spectrum signal, used for the driving of said broad spectrum sensor 1, being spread in a broad spectrum.

2. The device as set forth in claim 1,
wherein said spread spectrum signal to be generated from said spread spectrum signal generator 2 is based on an m-sequence code.

3. The device as set forth in claim 1,
wherein said spread spectrum signal to be generated from said spread spectrum signal generator 2 is generated by phase-modulating a carrier wave having a sine wave or square wave shape according to the logic value of the m-sequence code, the m-sequence code being generated by using a clock frequency at least ten times as large as said required bandwidth by the physical quantity to be measured.

4. The device as set forth in claim 1,
wherein said spread spectrum signal generator 2 changes the frequency of a carrier wave having either sine wave or square wave shape according to the logic value of the m-sequence code generated using a clock frequency at least ten times as large as said required bandwidth by the physical quantity to be measured.

5. The device as set forth in claim 1,
wherein said sensor driving circuit 3 has a differential output circuit so that the deterioration of the S/N ratio of said electric signal corresponding to said physical quantity is suppressed by a difference in the properties of the rise and fall of a signal from said sensor driving circuit 3.

6. The device as set forth in claim 1,
wherein said broad spectrum sensor is a Hall element.

7. A small magnetic field detection device, comprising:
a Hall element for outputting an electric signal corresponding to the intensity of a magnetic field while the Hall element is being driven electrically;
a spread spectrum signal generator for generating a spread spectrum signal;
a spread spectrum driving circuit for electrically driving said Hall element according to the spread spectrum signal output from said spread spectrum signal generator so as to spread the spectrum of said electric signal corresponding to said magnetic field detected by said Hall element;
a demodulation circuit for de-spreading the spectrum of said electric signal corresponding to said magnetic field detected by said Hall element into the required bandwidth for said magnetic field amount to be measured through synchronous detection by using said spread spectrum signal output from said spread spectrum signal generator, and for low-pass filtering said electric signal while a noise component having no correlation with said spread spectrum signal, used for the driving of said Hall element being spread in a broad spectrum.

8. A physical quantity detection method, comprising the steps of:
outputting an electric signal corresponding to a physical quantity detected through an electric drive of a broad spectrum sensor;
driving said broad spectrum sensor and outputting a spread spectrum signal output, as a spread spectrum output signal, said electric signal corresponding to said physical quantity detected by said broad spectrum sensor;
de-spreading the spectrum of said electric signal corresponding to said physical quantity detected by said broad spectrum sensor into the required bandwidth for said physical quantity to be measured through synchronous detection by using said spread spectrum signal output; and
low-pass filtering said electric signal while a noise component having no correlation with said spread spectrum signal, used for the driving of said broad spectrum sensor being spread in a broad spectrum, thereby outputting said physical quantity to be measured in said required bandwidth.
